# EUROPEAN PATENT SPECIFICATION

(11) **EP 4 546 340 B1**
(45) Date of publication and mention of the grant of the patent: **22.04.2026**
(21) Application number: 24175030.6
(22) Date of filing: 09.05.2024
(51) Int. Cl.: G11C 5/02, G11C 7/06, G11C 7/18, G11C 11/22, G11C 11/4091, G11C 11/4097, G11C 11/413

(54) **SEMICONDUCTOR MEMORY DEVICE WITH STACKED CHIPS STRUCTURE**
HALBLEITERSPEICHERANORDNUNG MIT GESTAPELTER CHIPSTRUKTUR
DISPOSITIF DE MÉMOIRE À SEMI-CONDUCTEUR AVEC STRUCTURE DE PUCES EMPILÉES

(30) Priority: 27.10.2023 KR 20230145526
(43) Date of publication of application: 30.04.2025
(73) Proprietor: Samsung Electronics Co., Ltd., Suwon-si, Gyeonggi-do 16677 (KR)
(72) Inventor: LEE, Hoseok, Suwon-si (KR); KANG, Kyu-Chang, Suwon-si (KR); JEONG, Kangsub, Suwon-si (KR); KIM, Dayoung, Suwon-si (KR); PARK, Young Seok, Suwon-si (KR)
(74) Representative: Marks & Clerk LLP

(56) References cited:
- US-A1- 2021 125 660
- US-A1- 2022 358 993

## Description

### BACKGROUND

### (a) Field

The present disclosure relates to semiconductor memory devices. More particularly, the present disclosure relates to semiconductor memory devices having a structure in which a memory cell array and a bit line sense amplifier (BLSA; also referred to as a sense amplifier, hereinafter) are positioned on different wafers and vertically overlap.

### (b) Description of the Related Art

Semiconductor memory devices may be classified into volatile memory devices and non-volatile memory devices. Volatile memory devices lose stored data when the power supply is cut off, whereas non-volatile memory devices retain stored data even when the power supply is cut off. Volatile memory devices include DRAM, FRAM, or the like.

In order to improve the integration of semiconductor memory devices, various cell structures are being developed, and a structure in which the memory cell array and the sense amplifier that detects the data stored in the memory cells are formed on different chips and arranged to vertically overlap each other is being developed. Patent publication US 2022/0358993 A1, to Chieh Lee et al, discusses a memory structure including first and second memory arrays, with bit lines connecting to first and second sense amplifiers under the first and second memory arrays.

### SUMMARY

Some example embodiments provide semiconductor memory devices with stacked chips structures in which wires are efficiently disposed.

Some example embodiment reduce coupling between a bit line and a complementary bit line in a semiconductor memory device with a stacked chips structure.

According to an example embodiment, a semiconductor memory device includes a first chip including a first array matrix and a second array matrix adjacent to each other, with a boundary region between the first array matrix and the second array matrix, the first array matrix and the second array matrix each including a plurality of memory cells, and a second chip below the first chip, the second chip including a plurality of sense amplifiers configured to drive the memory cells of the first array matrix and the second array matrix. Within the first chip, a plurality of first cell bit lines are in the first array matrix, a plurality of second cell bit lines are in the second array matrix, a plurality of first bit lines and a plurality of first complementary bit lines extend in a different layer from the memory cells, below the first array matrix, on a first matrix array-side of the boundary region, and a plurality of second bit lines and a plurality of second complementary bit lines extend in a different layer from the memory cells, below the second array matrix, on a second matrix array-side of the boundary region, and each of the first bit lines is connected to one of the first cell bit lines, each of the first complementary bit lines is connected to one if the second cell bit lines, each of the second bit lines is connected to one of the second cell bit lines, each of the second complementary bit lines is connected to one of the first cell bit lines. The sense amplifiers include a plurality of first sense amplifiers of which at least a portion is below the first array matrix and a plurality of second sense amplifiers of which at least a portion is below the second array matrix. A pair of one of the first bit lines and a corresponding one of the first complementary bit lines are connected to a corresponding one of the first sense amplifiers, and a pair of one of the second bit lines and a corresponding one of the second complementary bit lines are connected to a corresponding one of the second sense amplifiers. The bit lines extend in a first direction, and are spaced apart from each other in a second direction, perpendicular to the first direction, and the first chip is stacked on the second chip in a third direction, perpendicular to the first and second directions. Between the one of the first bit lines and the corresponding one of the first complementary bit lines commonly connected to the corresponding one of the first sense amplifiers, in the second direction, at least one of a shield line, another one of the first bit lines, or another one of the first complementary bit lines is positioned. Among the one of the first bit lines and the corresponding one of the first complementary bit lines that are commonly connected to the corresponding one of the first sense amplifiers, one is a straight line, and the other one is a refracted line, a refracted line having a first portion and a second portion that extend in the first direction, the first and second portions having at least one of a shield line, another one of the first bit lines, or another one of the first complementary bit lines disposed therebetween, and the first and second portions connected by a connection portion that extends in the second direction crossing the first direction and crossing, in an insulated state, the at least one of the shield line, another one of the first bit lines, or another one of the first complementary bit lines disposed between the first and second portions.

According to an example embodiment, a semiconductor memory device includes a first chip including an array matrix including a plurality of memory cells, and a second chip including a plurality of sense amplifiers, the sense amplifiers being below the first chip and configured to drive memory cells of the array matrix. A plurality of cell bit lines are in the array matrix, a plurality of bit lines and a plurality of complementary bit lines are below the array matrix, a pair of one of the bit lines and a corresponding one of the complementary bit lines are connected to a corresponding one of the sense amplifiers, and at least one of a shield line, a second one of the bit lines, or a second one of the complementary bit lines is between a pair of one of the bit lines and a corresponding one of the complementary bit lines commonly connected to a corresponding one of the sense amplifiers.

According to an example embodiment, a semiconductor memory device includes a first chip including an array matrix including a plurality of memory cells, and a second chip including a plurality of sense amplifiers, the sense amplifiers being below the first chip and configured to drive memory cells of the array matrix. A plurality of cell bit lines are in the array matrix, a plurality of bit lines and a plurality of complementary bit lines are below the array matrix, and a pair of one of the bit lines and a corresponding one of the complementary bit lines are connected to a corresponding one of the sense amplifiers. The second chip includes a plurality of lower bonding pads, a plurality of first connection layers, and a plurality of second connection layers that connect the bit lines and the complementary bit lines to the sense amplifiers. One of the first connection layers is connected to a first input terminal of a corresponding one of the sense amplifiers, and a corresponding one of the second connection layers is connected to a second input terminal of the corresponding one of the sense amplifiers, each of the first connection layers is connected to a corresponding one of the lower bonding pads, and each of the second connection layers is connected to a corresponding one of the lower bonding pads.

According to an example embodiment, by efficiently disposing a wire connecting the memory cell and the sense amplifier, the length of the wire may be reduced.

According to an example embodiment, by disposing wires connecting other bit lines or complementary bit lines to the sense amplifier between wires connecting the bit line and the complementary bit line to the sense amplifier, coupling between the bit line and the complementary bit line may be reduced.

At least some of the above and other features of the invention are set out in the claims.

### BRIEF DESCRIPTION OF THE DRAWINGS

FIG. 1 is a layout view of a semiconductor memory device according to an example embodiment.
FIG. 2 is a cross-sectional view showing a connection between the sense amplifier and BLB1 of FIG. 1.
FIG. 3 is a cross-sectional view showing a connection between the sense amplifier and BL1 of FIG. 1.
FIG. 4 is a cross-sectional view showing a connection between the sense amplifier and BL3 of FIG. 1.
FIG. 5 is a cross-sectional view showing a connection between the sense amplifier and BLB3 of FIG. 1.
FIG. 6 is an enlarged layout view of portion A1 of FIG. 1.
FIG. 7 is a cross-sectional view taken along line A-A' of FIG. 6.
FIG. 8 is a layout view showing a connection of wires, centered on the bonding pad with different aspect ratios of portion A2 of FIG. 6.
FIG. 9 is a schematic view showing a connection between the sense amplifier and the bonding pad on a peripheral circuit chip in a semiconductor memory device according to an example embodiment.
FIG. 10 is a schematic view showing a connection between the sense amplifier and the bonding pad on a peripheral circuit chip in a semiconductor memory device according to another example embodiment.

### DETAILED DESCRIPTION

The present disclosure will be described more fully hereinafter with reference to the accompanying drawings, in which some example embodiments of the disclosure are shown. As those skilled in the art would realize, the described example embodiments may be modified in various different ways without departing from the scope of the present disclosure.

The drawings and the descriptions described herein should be considered in a descriptive sense only and not for purposes of limitation. Throughout the specification, the same reference numbers indicate the same constituent elements.

In the drawings, the size and thickness of each constituent element may be arbitrarily shown for better understanding and ease of description, and the present disclosure is not necessarily limited to what is shown in the drawings. In the drawings, the thickness of layers, films, plates, panels, regions, areas, and the like may be exaggerated for clarity. In the drawings, the thickness of some layers, areas, and regions may be exaggerated for better understanding and ease of description.

As used herein, the singular forms (for example, a, an, and the) are intended to include the plural forms as well (and vice versa), unless the context clearly indicates otherwise.

In the specification and the claims, the term "and/or" is intended to include any combination of the terms "and" and "or" for the purpose of its meaning and interpretation. For example, "A and/or B" may be understood to mean "A, B, or A and B."

In the specification and the claims, the phrase "at least one of" is intended to include the meaning of "at least one selected from the group of" for the purpose of its meaning and interpretation. For example, "at least one of A and B" and "at least one of A or B" may be understood to mean "A, B, or A and B."

Terms such as first, second, and the like will be used only to describe various constituent elements, and are not to be interpreted as limiting these constituent elements. The terms are only used to differentiate one constituent element from other constituent elements. For example, a first constituent element could be termed a second constituent element, and similarly, a second constituent element could be termed as a first constituent element, without departing from the scope of the present disclosure.

When an element, such as a layer, a film, a region, an area, or a substrate is described to be "above" another element, it may be directly above another element or there may be an intermediate element. In contrast, when a first element is described to be "directly above" a second element, there is no intermediate element. Throughout the specification, the term "above" a target must be "understood as being disposed above or below the target element, and does not necessarily signify "above" with respect to an opposite direction of gravity. The terms "above" and "below" may refer to relative positions along a height direction (e.g. a direction in which first and second chips of the semiconductor device are stacked). For instance, an element that is "above" another element may be located further along the height direction than the other element.

For example, spatially relative terms "below" or "above" may be used to facilitate the description of the relationship of one element or a constituent element to other constituent elements as shown in the drawings. The spatially relative terms are intended to include other directions in use or operation in addition to the directions shown in the drawings. For example, when the device shown in the drawing is flipped, the device disposed below another device may be disposed "above" the other device. Therefore, the example term "below" may include lower and upper positions. The device may also be oriented in other directions, the spatially relative term may be analyzed differently depending on the directions.

When an element (or region, area, layer, portion, etc.) is described to be "connected" or "combined" to another element in the specification, it may be directly disposed, connected, or combined on the above-noted other element, or an element may be disposed therebetween.

The term "connected to" or "combined to" may include physical or electrical connections or combinations.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

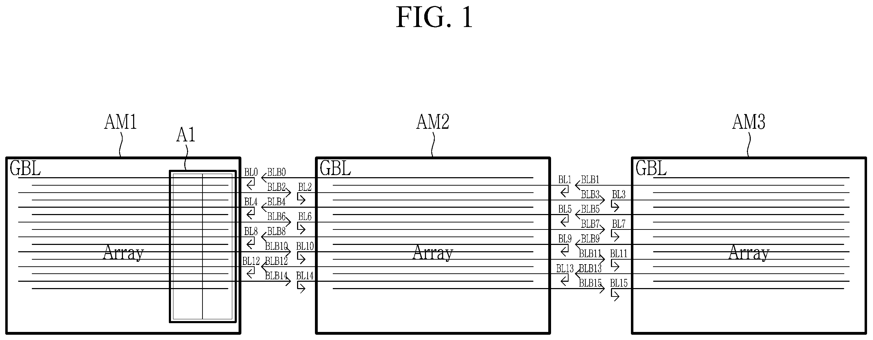

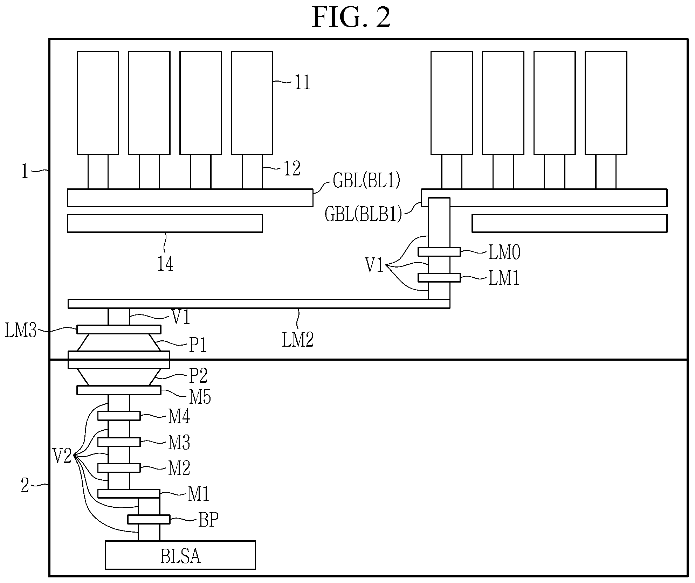

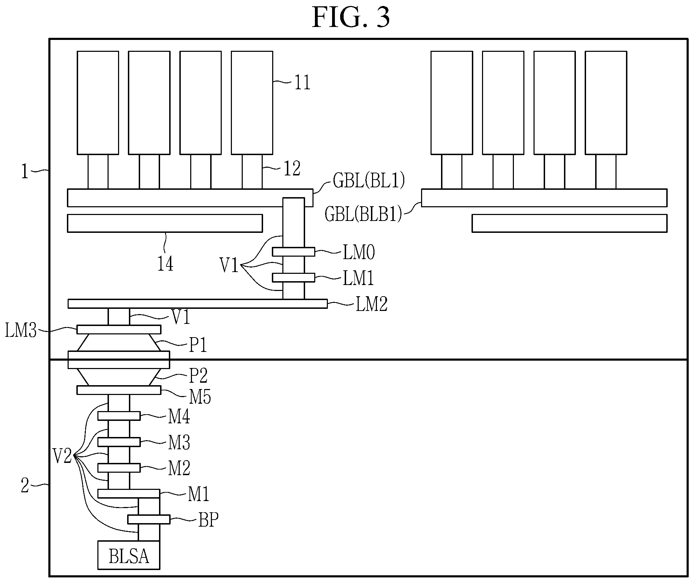

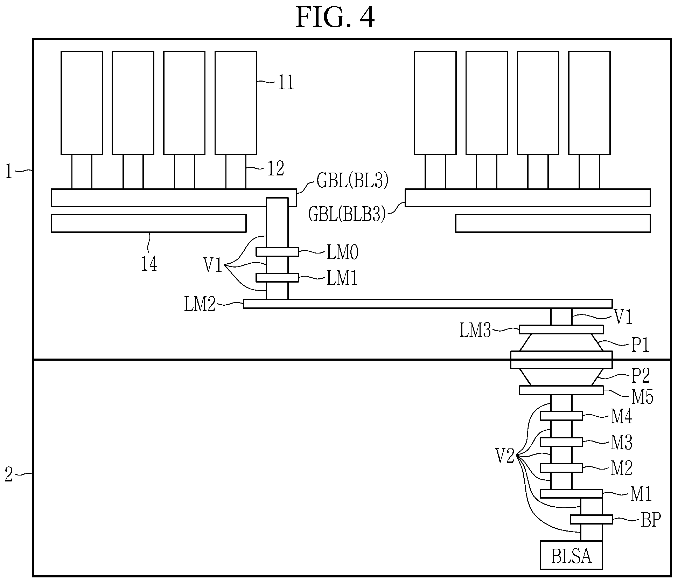

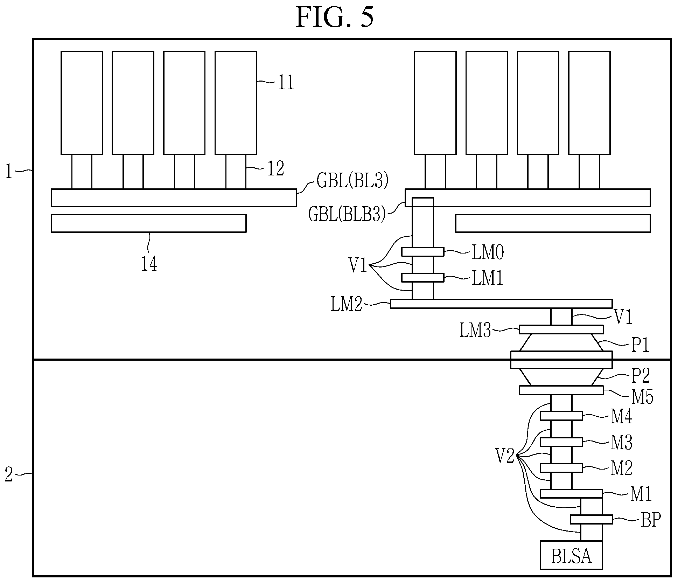

FIG. 1 is a layout view of a semiconductor memory device according to an example embodiment. FIG. 2 is a cross-sectional view showing a connection between the sense amplifier and BLB1 of FIG. 1. FIG. 3 is a cross-sectional view showing a connection between the sense amplifier and BL1 of FIG. 1. FIG. 4 is a cross-sectional view showing a connection between the sense amplifier and BL3 of FIG. 1. FIG. 5 is a cross-sectional view showing a connection between the sense amplifier and BLB3 of FIG. 1.

Referring to FIG. 1, a semiconductor memory device may include a plurality of array matrices AM1, AM2, and AM3 each including a plurality of memory cells. Each of the plurality of array matrices AM1, AM2, and AM3 may include a plurality of cell bit lines GBL and a plurality of word lines, and memory cells may be disposed in regions where the plurality of cell bit lines GBL and the plurality of word lines intersect. Each bit line may extend in a first direction (e.g. an X-direction) and the bit lines may be spaced apart from each other in a second direction (e.g. a Y-direction). The first direction and second direction may intersect (e.g. may be perpendicular to each other). A third direction (e.g. a height direction, or Z-direction) may be defined to be perpendicular to the first and second directions. Here, the plurality of memory cells may be volatile memory cells such as DRAM, resistive memory cells such as phase-change RAM (PRAM) and resistive RAM (RRAM), or may be nano-floating gate memory (NFGM), polymer RAM (PoRAM), magnetic RAM (MRAM), ferroelectric RAM (FeRAM) or flash memory cells. Each memory cell may include a cell capacitor and a transistor, which connects or blocks the cell capacitor to a cell bit line GBL, and the transistor includes a channel that is turned on and off according to a word line (WL) signal. Here, the channel may be formed perpendicular to the array matrices AM1, AM2, and AM3, and may connect the cell bit line GBL below the channel to a cell capacitor above the channel.

The cell bit lines GBL included in two neighboring ones of the array matrices AM1, AM2, and AM3 are separated, and the cell bit lines GBL, the word lines, and the memory cells may not be disposed in a boundary region between the array matrices AM1, AM2, and AM3.

Each of the cell bit lines GBL may be connected to bit lines BL0, BL1, BL2, and ... or complementary bit lines BLB0, BLB1, BLB2, and .... A bit of data may be read based on the difference between a signal on a specific bit line and a signal on a complementary bit line corresponding to the specific bit line, instead of being based on a signal from either a bit line or a complementary bit line by itself. Referring to FIG. 1, an uppermost cell bit line GBL of a second array matrix AM2 may be connected to a complementary bit line BLB0, and the cell bit lines GBL thereunder (e.g. in the second direction) may be sequentially connected to a bit line BL1, a bit line BL2, a complementary bit line BLB3, a complementary bit line BLB4, a bit line BL5, a bit line BL6, a complementary bit line BLB7, a complementary bit line BLB8, and .... The connection of the cell bit line GBL and the bit lines BL0, BL1, BL2, and ... or the complementary bit lines BLB0, BLB1, BLB2, and ... may be made in a boundary region between the array matrices AM1, AM2, and AM3.

Referring to FIG. 1, FIG. 2, FIG. 3, FIG. 4 and FIG. 5, the bit lines BL0, BL1, BL2, and ... and the complementary bit lines BLB0, BLB1, BLB2, and ... may be positioned in a different layer from the memory cells, specifically, below the memory cells. The bit lines BL0, BL1, BL2, and ... and the complementary bit lines BLB0, BLB1, BLB2, and ... may be a portion of a wire connecting the cell bit line GBL and a sense amplifier BLSA. The sense amplifier BLSA may be configured to sense data stored in a corresponding set of memory cells.

Referring to FIG. 2, FIG. 3, FIG. 4 and FIG. 5, a semiconductor memory device according to an example embodiment may include a memory cell array chip 1 in which the plurality of memory cells are positioned and a peripheral circuit chip 2 in which the sense amplifiers BLSA are positioned. The memory cell array chip 1 may be stacked on the peripheral circuit chip 2 in the third direction (e.g. the Z-direction).

The memory cell array chip 1 may include a cell capacitor 11, a vertical channel transistor 12, the cell bit line GBL, a bit line shield layer 14, upper wires LM0, LM1, LM2, and LM3 and upper vias V1 forming at least a portion of the bit lines BL1 and BL3 and complementary bit lines BLB1 and BLB3, an upper bonding pad P1, or the like. The upper bonding pad P1 may include copper (Cu). The cell capacitor 11 may be connected to the cell bit line GBL through the vertical channel transistor 12, and the cell bit line GBL may be connected to the bit lines BL1 and BL3 or the complementary bit lines BLB1 and BLB3 that include at least a portion of the upper vias V1 and the upper wires LM0, LM1, LM2, and LM3 in a boundary region between the array matrices AM1, AM2, and AM3. Between the cell capacitor 11, the vertical channel transistor 12, the cell bit line GBL, the bit line shield layer 14, the upper wires LM0, LM1, LM2, and LM3, the upper via V1, the upper bonding pad P1, or the like, a single or a plurality of insulation layers may be positioned so as to insulate them from each other. The bit line shield layer 14 may be a layer to block or prevent the cell bit line GBL from being affected by an electric signal flowing through a circuit wire thereunder. That is, the bit line shield layer 14 may act as a shield for the cell bit line GBL against electromagnetic effects caused by the electric signal flowing through a circuit wire thereunder. The peripheral circuit chip 2 may include various peripheral circuits for driving memory cells such as a sub-word line driver, a row decoder, a column decoder as well as the sense amplifier BLSA. In addition, the peripheral circuit chip 2 may include a lower bonding pad P2, lower wires M1, M2, M3, M4, and M5 connecting the sense amplifier BLSA and the lower bonding pad P2, a connection layer BP, lower vias V2, and the like. The lower bonding pad P2 may include copper. The sense amplifier BLSA may be positioned below the array matrices AM1, AM2, and AM3, and may vertically overlap the cell bit line GBL and the bit lines BL1 and BL3, and the complementary bit lines BLB1 and BLB3. The connection layer BP may include polysilicon. The memory cell array chip 1 and the peripheral circuit chip 2 may be bonded such that the upper bonding pad P1 and the lower bonding pad P2 are aligned to contact each other. Through such bonding, the cell bit line GBL may be connected to the sense amplifier BLSA.

Referring to FIG. 1, FIG. 2, FIG. 3, FIG. 4 and FIG. 5, the bit line BL1 and the complementary bit line BLB1 may extend below the array matrix AM2, which is on the left side of a boundary region between the array matrix AM2 and the array matrix AM3 (hereinafter, referred to as a "boundary region left side"), and a bit line BL3 and the complementary bit line BLB3 may extend below an array matrix AM3 on the right side of the boundary region between the array matrix AM2 and the array matrix AM3 (hereinafter, referred to as a "boundary region right side"). Subsequently, the bit line BL5 and a complementary bit line BLB5 may extend below the array matrix AM2 on the boundary region left side, and a bit line BL7 and the complementary bit line BLB7 may extend below the array matrix AM3 on the boundary region right side. As such, in the boundary region between the array matrix AM2 and the array matrix AM3, odd numbered bit lines BL1, BL3, BL5, and ... and odd numbered complementary bit lines BLB1, BLB3, BLB5, and ... may be connected to the cell bit lines GBL, and the bit lines BL1, BL3, BL5, and ... and the complementary bit lines BLB1, BLB3, BLB5, and ... corresponding thereto may extend in the same direction. In addition, the bit lines BL1, BL3, BL5, and ... and the complementary bit lines BLB1, BLB3, BLB5, and ... corresponding thereto may alternately extend to the left and to the right sequentially from the top (e.g. in descending order along the second direction).

As such, when the bit lines BL1, BL3, BL5, and ... and the complementary bit lines BLB1, BLB3, BLB5, and ... corresponding thereto extend in the same direction and alternately extend left and right, wires may be efficiently disposed, such that their lengths may be reduced.

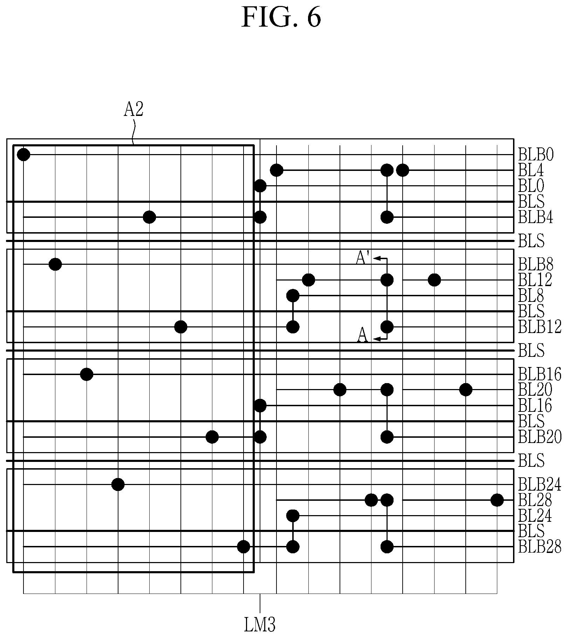

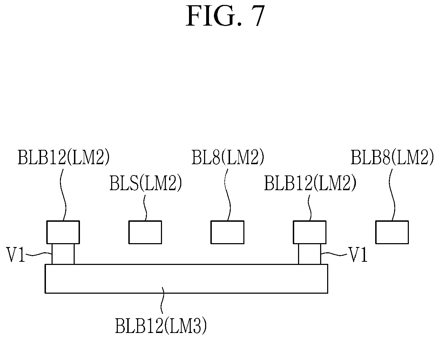

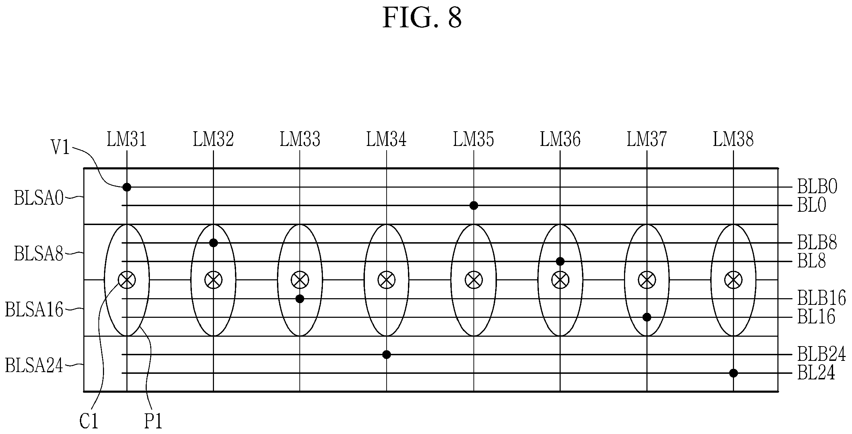

FIG. 6 is an enlarged layout view of portion A1 of FIG. 1. FIG. 7 is a cross-sectional view taken along line A-A' of FIG. 6. FIG. 8 is a layout view showing a connection of wires, centered on the bonding pad with different aspect ratios of portion A2 of FIG. 6.

Referring to FIG. 6, between bit lines BL0, BL8, and ... and complementary bit lines BLB4, BLB12, and ..., between two sense amplifiers BLSA neighboring each other, a shield line BLS may be positioned, respectively. The shield line BLS may reduce signal interference between bit line and complementary bit line neighboring each other.

Referring to FIG. 6 and FIG. 7, the shield line BLS, some bit lines BL4, BL12, BL20, BL28, and ... and some complementary bit lines BLB0, BLB8, BLB16, BLB24, and ... may extend in a straight line, and remainders (e.g., the bit lines BL0, BL8, BL16, BL24, and ... and the complementary bit lines BLB4, BLB12, BLB20, a BLB 28, and ...) may be refracted lines having plural bent points. Depending on example embodiments, the bit lines BL0, BL8, BL16, BL24, and ... and the complementary bit lines BLB4, BLB12, BLB20, the BLB 28, and ... may be straight lines, and the bit lines BL4, BL12, BL20, BL28, and ... and the complementary bit lines BLB0, BLB8, BLB16, BLB24, and ... may be refracted lines. As described herein, a refracted line may be a line that has multiple bent portions. A refracted line may be a line having two or more portions (e.g. longitudinal portions) that extend in the first direction, wherein each successive pair of portions within a refracted line is connected by a corresponding connection portion (e.g. a transverse portion) that extends in a direction crossing the first direction (e.g. the second direction). Each connecting portion may be between two corresponding bent portions in the refracted line. The combination of two portions and a connecting portion may form a step. A refracted line may be otherwise known as a bent line or a stepped line. The straight lines and the refracted lines may be selected in various ways. The shield line BLS, some of the bit lines (e.g., BL4, BL12, BL20, BL28, and ...) and some of the complementary bit lines (e.g., BLB0, BLB8, BLB16, BLB24, and ...) that extend in straight lines may include a third upper wire LM2, and some of the bit lines (e.g., BL0, BL8, BL16, BL24, and ...) and some of the complementary bit lines (e.g., BLB4, BLB12, BLB20, the BLB 28, and ...) that are refracted lines may include the third upper wire LM2, a fourth upper wire LM3, and the upper via V1 connecting the third upper wire LM2, a fourth upper wire LM3 to each other. The bit lines BL0, BL8, BL16, BL24, and ... and the complementary bit lines BLB4, BLB12, BLB20, the BLB 28, and ... that are refracted lines may include two portions positioned at both sides interposing the shield line BLS and/or the bit lines BL0, BL8, BL16, BL24, and ..., respectively, and these two portions may be connected to each other by crossing the shield line BLS and/or the bit lines BL0, BL8, BL16, BL24, and ... disposed therebetween (e.g. by a connection portion), in an insulated state. At this time, two portions positioned at both sides of the shield line BLS and/or the bit lines BL0, BL8, BL16, BL24, and ... may be the third upper wire LM2, and a portion connecting these two portions may be the fourth upper wire LM3 and the upper vias V1. For example, referring to FIG. 7, two portions BLB12 (LM2) of a complementary bit line BLB12 may be positioned at both sides of a shield line BLS (LM2) and a bit line BL8 (LM2), a connection portion BLB12 (LM3) connecting these two portions BLB12 (LM2) may be positioned thereunder in a different layer, and the connection portion BLB12 (LM3) may be connected to the two portions BLB12 (LM2) of the complementary bit line BLB12 through the upper vias V1.

Through the example arrangements, it is possible to block or prevent the bit line and the corresponding complementary bit line from neighboring each other (e.g. adjacent to each other in the second direction). That is, through the example embodiments above, a first bit line and a second bit line that is complementary to the first bit line may be arranged in a way that they are not directly adj acent to each other. For example, at least one of another bit line, another complementary bit line, or a shield line may be located between the bit line and the corresponding complementary bit line (e.g. in the second direction). For example, referring to FIG. 6, a portion of the complementary bit line BLB4 and a bit line BL4 may be positioned between the complementary bit line BLB0 and a bit line BL0. The bit line BL0 and the shield line BLS may be positioned between the bit line BL4 and the complementary bit line BLB4. Through these example arrangements, signal interference between the bit line and the complementary bit line corresponding thereto may be mitigated.

Referring to FIG. 6 and FIG. 8, bit lines BL0, BL4, BL8, BL12, BL16, BL20, BL24, BL28, and ... and complementary bit lines BLB0, BLB4, BLB8, BLB12, BLB16, BLB20, BLB24, BLB28, and ... may be connected to one of the fourth upper wires LM3 that vertically extend (e.g. that extend in the second direction). Referring to FIG. 8, the complementary bit line BLB0 may be connected to a fourth upper wire LM31 through an upper via V1, and the bit line BL0 may be connected to a fourth upper wire LM35 through an upper via V1. Subsequently, a complementary bit line BLB8 may be connected to a fourth upper wire LM32 through an upper via V1, and the bit line BL8 may be connected to a fourth upper wire LM36 through an upper via V1. A complementary bit line BLB16 may be connected to a fourth upper wire LM33 through an upper via V1, and a bit line BL16 may be connected to a fourth upper wire LM37 through an upper via V1. A complementary bit line BLB24 may be connected to a fourth upper wire LM34 through an upper via V1, and a bit line BL24 may be connected to a fourth upper wire LM38 through an upper via V1. Each connection between a bit line BL0, BL4, BL8, BL12, BL16, BL20, BL24, BL28, and ... or complementary bit line BLB0, BLB4, BLB8, BLB12, BLB16, BLB20, BLB24, BLB28, and ... and a fourth upper wire LM3 may be provided by a corresponding one of the upper vias V1.

Referring to FIG. 2 and FIG. 8, fourth upper wires LM3 (LM31, LM32, LM33, LM34, LM35, LM36, LM37, LM38) that vertically extend (e.g. that extend in the second direction) may be connected to the upper bonding pad P1 through a contact hole C1. The upper bonding pad P1 may be bonded to a corresponding lower bonding pad P2 and thereby may be connected to a sense amplifier BLSA (BLSA0, BLSA8, BLSA16, BLSA24), respectively, through the lower wires M1, M2, M3, M4, and M5, the connection layer BP, the lower via V2, and the like.

FIG. 8 illustrates the upper bonding pad P1 in an elliptical shape, but depending on example embodiments, it may be a circle, a polygon, or the like. FIG. 8 illustrates that the upper bonding pads P1 are positioned in line above the two central sense amplifiers BLSA8 and BLSA16, but depending on example embodiments, they may be positioned above other sense amplifiers BLSA1 and BLSA24, or their positions may be vertically altered (e.g. in the second direction).

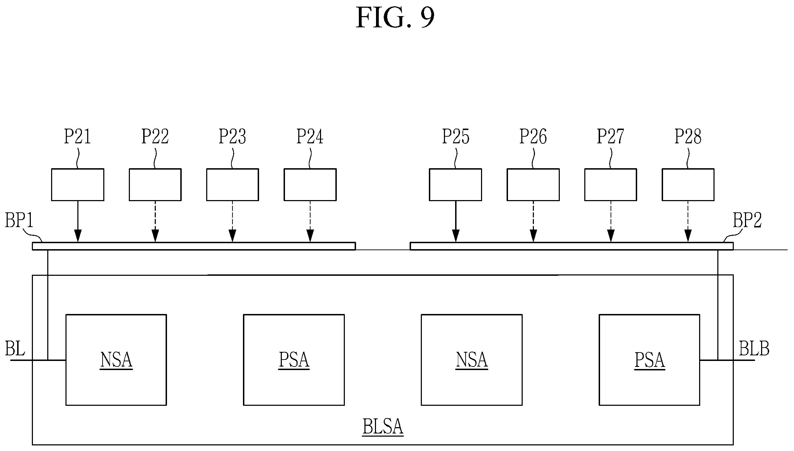

FIG. 9 is a schematic view showing a connection between the sense amplifier and the bonding pad on a peripheral circuit chip in a semiconductor memory device according to an example embodiment.

Referring to FIG. 9, the sense amplifier BLSA may include a plurality of n-type metal-oxide-semiconductor (NMOS) sense amplifier drivers (NSA), a plurality of p-type metal-oxide-semiconductor (PMOS) sense amplifier drivers (PSA), a bit line lead-in line BL input or connected to one of the NSAs, and a complementary bit line lead-in line BLB input or connected to one of the PSAs. Above the sense amplifier BLSA, a first connection layer BP1 and a second connection layer BP2 may be positioned, the first connection layer BP1 may be connected to the bit line lead-in line BL, and the second connection layer BP2 may be connected to the complementary bit line lead-in line BLB. The first connection layer BP1 may be positioned to correspond to lower bonding pads P21, P22, P23, and P24 on the left side half among a plurality of lower bonding pads P21, P22, P23, P24, P25, P26, P27, and P28, and the second connection layer BP2 may be positioned to correspond to lower bonding pads P25, P26, P27, and P28 on the right side half among the plurality of lower bonding pads P21, P22, P23, P24, P25, P26, P27, and P28. The first connection layer BP1 and the second connection layer BP2 may include polysilicon. The first connection layer BP1 may be connected to one (e.g., P21) of the lower bonding pads P21, P22, P23, and P24 on the left side, and the second connection layer BP2 may be connected to one (e.g., P25) of the lower bonding pads P25, P26, P27, and P28 on the right side. When the first connection layer BP1 and the second connection layer BP2 are disposed as such, the wire for connecting the lower bonding pads P21, P22, P23, P24, P25, P26, P27, and P28 and the sense amplifier BLSA may be efficiently disposed, and accordingly, the length of wire may be reduced.

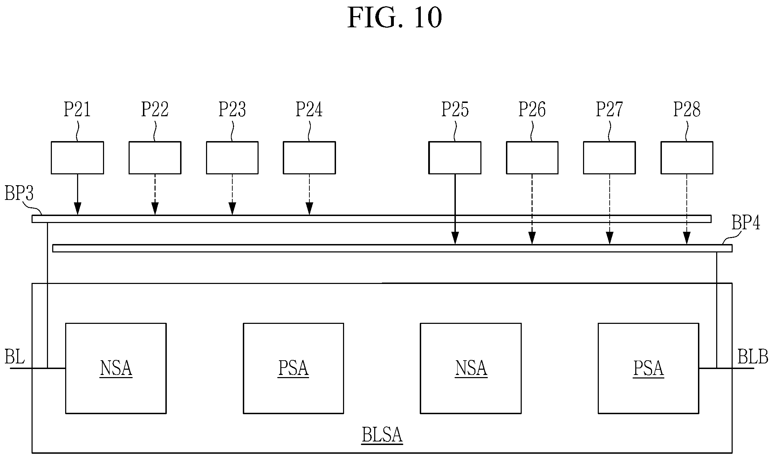

FIG. 10 is a schematic view showing a connection between the sense amplifier and the bonding pad on a peripheral circuit chip in a semiconductor memory device according to another example embodiment.

Referring to FIG. 10, the sense amplifier BLSA may include a plurality of NMOS sense amplifier drivers (NSA), a plurality of PMOS sense amplifier drivers (PSA), and a bit line lead-in line (or a bit line) BL input or connected to one of the NSAs and a complementary bit line lead-in line (or a complementary bit line) BLB input or connected to one of the PSAs. Above the sense amplifier BLSA, the first connection layer BP3 and the second connection layer BP4 may be positioned, and the first connection layer BP3 may be connected to the bit line lead-in line BL, and the second connection layer BP4 may be connected to the complementary bit line lead-in line BLB. All of the first connection layer BP1 and the second connection layer BP2 may be positioned to correspond to all of the plurality of lower bonding pads P21, P22, P23, P24, P25, P26, P27, and P28. The first connection layer BP1 and the second connection layer BP2 may include polysilicon. The first connection layer BP1 and the second connection layer BP2 may be positioned in a different layer, or may be positioned on the same layer but at different position on the same plane. The first connection layer BP1 may be connected to one (e.g., P21) of the lower bonding pads P21, P22, P23, and P24 on the left side, and the second connection layer BP2 may be connected to one (e.g., P 25) of the lower bonding pads P25, P26, P27, and P28 on the right side. When the first connection layer BP1 and the second connection layer BP2 are disposed as such, the wire for connecting the lower bonding pads P21, P22, P23, P24, P25, P26, P27, and P28 and the sense amplifier BLSA may be efficiently disposed, and accordingly, the length of wire may be reduced.

Referring again to FIG. 10, a group of the plurality of lower bonding pads (e.g., P21, P22, P23, P24, P25, P26, P27, and P28) correspond to or vertically overlap (e.g. in a height direction, or Z-direction) both the first connection layers BP3 and the second connection layer BP4 corresponding to the first connection layers BP3. Further, half of the group of the lower bonding pads (e.g., P21, P22, P23, and P24) are connected to the bit line BL, the remaining half (e.g., P25, P26, P27, and P28 are connected to the complementary bit line BLP. The first connection layer BP3 is connected to one input terminal of a corresponding sense amplifier BLSA, and the second connection layer BP4 corresponding to the first connection layer BP3 is connected to another input terminal of the corresponding sense amplifier BLSA.

While some example embodiments of the disclosure are described with reference to the attached drawings, those with ordinary skill in the technical field of the present disclosure pertains will be understood that the present disclosure may be carried out in other specific forms without changing the technical idea or essential features. Therefore, it is to be understood that the above-described example embodiments are for illustrative purposes only, and the scope of the present disclosure is not limited thereto, but rather defined by the appended claims.

## Claims

1. A semiconductor memory device, comprising:
a first chip (1) including a first array matrix (AM1) and a second array matrix (AM2) adjacent to each other, with a boundary region between the first array matrix (AM1) and the second array matrix (AM2), the first array matrix (AM1) and the second array matrix (AM2) each including a plurality of memory cells; and
a second chip (2) below the first chip (1), the second chip (2) including a plurality of sense amplifiers (BLSA) configured to drive the memory cells of the first array matrix (AM1) and the second array matrix (AM2),
wherein, within the first chip (1):
a plurality of first cell bit lines (GBL) are in the first array matrix (AM1), and a plurality of second cell bit lines (GBL) are in the second array matrix (AM2),
a plurality of first bit lines (BLO, BL4, BL8, BL12) and a plurality of first complementary bit lines (BLBO, BLB4, BLB8, BLB12) extend in a different layer from the memory cells, below the first array matrix (AM1), on a first matrix array-side of the boundary region, and a plurality of second bit lines (BL2, BL6, BL10, BL14) and a plurality of second complementary bit lines (BLB2, BLB6, BLB10, BLB14) extend in a different layer from the memory cells, below the second array matrix (AM2), on a second matrix array-side of the boundary region, and
each of the first bit lines (BLO, BL4, BL8, BL12) is connected to one of the first cell bit lines (GBL), each of the first complementary bit lines (BLBO, BLB4, BLB8, BLB12) is connected to one of the second cell bit lines (GBL), each of the second bit lines (BL2, BL6, BL10, BL14) is connected to one of the second cell bit lines (GBL), and each of the second complementary bit lines (BLB2, BLB6, BLB10, BLB14) is connected to one of the first cell bit lines (GBL),
wherein the sense amplifiers (BLSA) comprise a plurality of first sense amplifiers (BLSA) of which at least a portion is below the first array matrix (AM1) and a plurality of second sense amplifiers (BLSA) of which at least a portion is below the second array matrix (AM2),
wherein a pair of one of the first bit lines (BLO, BL4, BL8, BL12) and a corresponding one of the first complementary bit lines (BLBO, BLB4, BLB8, BLB12) are connected to a corresponding one of the first sense amplifiers (BLSA),
wherein a pair of one of the second bit lines (BL2, BL6, BL10, BL14) and a corresponding one of the second complementary bit lines (BLB2, BLB6, BLB 10, BLB14) are connected to a corresponding one of the second sense amplifiers (BLSA),
wherein the bit lines extend in a first direction, and are spaced apart from each other in a second direction, perpendicular to the first direction, and the first chip (1) is stacked on the second chip (2) in a third direction, perpendicular to the first and second directions,
wherein, between the one of the first bit lines (BLO, BL4, BL8, BL12) and the corresponding one of the first complementary bit lines (BLBO, BLB4, BLB8, BLB12) commonly connected to the corresponding one of the first sense amplifiers (BLSA), in the second direction, at least one of a shield line (BLS), another one of the first bit lines (BLO, BL4, BL8, BL12), or another one of the first complementary bit lines (BLBO, BLB4, BLB8, BLB12) is positioned, and
wherein, among the one of the first bit lines (BLO, BL4, BL8, BL12) and the corresponding one of the first complementary bit lines (BLBO, BLB4, BLB8, BLB12) that are commonly connected to the corresponding one of the first sense amplifiers (BLSA), one is a straight line, and the other one is a refracted line, a refracted line having a first portion (BLB12(LM2)) and a second portion (BLB12(LM2)) that extend in the first direction, the first and second portions (BLB12(LM2)) having at least one of a shield line (BLS), another one of the first bit lines (BLO, BL4, BL8, BL12), or another one of the first complementary bit lines (BLBO, BLB4, BLB8, BLB12) disposed therebetween, and the first and second portions (BLB12(LM2)) connected by a connection portion (BLB12(LM3)) that extends in the second direction crossing the first direction and crossing, in an insulated state, the at least one of the shield line (BLS), another one of the first bit lines (BLO, BL4, BL8, BL12), or another one of the first complementary bit lines (BLBO, BLB4, BLB8, BLB12) disposed between the first and second portions (BLB12(LM2)).

2. The semiconductor memory device of claim 1, wherein:
the first cell bit lines (GBL) respectively connected to the first bit lines (BLO, BL4, BL8, BL12) and the first cell bit lines (GBL) respectively connected to the second complementary bit lines (BLB2, BLB6, BLB10, BLB14) alternate with each other; and
the second cell bit lines (GBL) respectively connected to the first complementary bit lines (BLBO, BLB4, BLB8, BLB12) and the second cell bit lines (GBL) respectively connected to the second bit lines (BL2, BL6, BL10, BL14) alternate with each other.

3. The semiconductor memory device of claim 2, wherein connections of the first bit lines (BLO, BL4, BL8, BL12) and the first cell bit lines (GBL), connections of the second complementary bit lines (BLB2, BLB6, BLB10, BLB14) and the first cell bit lines (GBL), connections of the first complementary bit lines (BLBO, BLB4, BLB8, BLB12) and the second cell bit lines (GBL), and connections of the second bit lines (BL2, BL6, BL10, BL14) and the second cell bit lines (GBL) are in the boundary region between the first array matrix (AM1) and the second array matrix (AM2).

4. The semiconductor memory device of claim 3, wherein each of the first bit lines (BLO, BL4, BL8, BL12), the first complementary bit lines (BLBO, BLB4, BLB8, BLB12), the second bit lines (BL2, BL6, BL10, BL14) and the second complementary bit lines (BLB2, BLB6, BLB10, BLB14) is in the first chip (1), and includes a plurality of upper wires (LM0, LM1, LM2, LM3) and a plurality of upper vias (V1).

5. The semiconductor memory device of claim 4, wherein the second chip (2) comprises a plurality of lower wires (M1, M2, M3, M4, M5) and a plurality of lower vias (V2) that connect the pair of one of the first bit lines and corresponding one of the first complementary bit lines, and the pair of one of the second bit lines and corresponding one of the second complementary bit lines to the sense amplifiers (BLSA).

6. The semiconductor memory device of claim 5, wherein:
the first chip (1) includes an upper bonding pad (P1) connected to the upper wires (LM0, LM1, LM2, LM3) or the upper vias (V1);
the second chip (2) includes a lower bonding pad (P2) connected to the lower wires (M1, M2, M3, M4, M5) or the lower vias (V2); and
the upper bonding pad (P1) and the lower bonding pad (P2) are bonded to each other.

7. The semiconductor memory device of claim 1, wherein at least the shield line (14) is positioned between the one of the first bit lines (BLO, BL4, BL8, BL12) and the corresponding one of the first complementary bit lines (BLBO, BLB4, BLB8, BLB12) commonly connected to the corresponding one of the first sense amplifiers (BLSA), and the refracted line crosses and is insulated from the shield line (BLS).

8. The semiconductor memory device of claim 7, wherein the first portion (BLB12(LM2)) and the second portion (BLB12(LM2)) are positioned at both sides of the shield line (BLS), the connection portion (BLB12(LM3)) crossing and insulated from the shield line (BLS), a first via (V1) connecting between the first portion (BLB12(LM2)) and the connection portion (BLB12(LM3)), and a second via (V1) connecting between the second portion (BLB12(LM2)) and the connection portion (BLB12(LM3)).

9. The semiconductor memory device of claim 8, wherein the refracted line crosses and is insulated from at least one among the first bit lines (BLO, BL4, BL8, BL12) and the first complementary bit lines (BLBO, BLB4, BLB8, BLB12).

10. The semiconductor memory device of any preceding claim, wherein:
the second chip (2) includes a plurality of lower bonding pads (P21, P22, ..., P27, P28), a plurality of first connection layers (BP3), and a plurality of second connection layers (BP4) that connect the first bit lines (BLO, BL4, BL8, BL12) and the first complementary bit lines (BLBO, BLB4, BLB8, BLB12) to the sense amplifiers (BLSA); and
one of the first connection layers (BP3) is connected to a first input terminal of a corresponding one of the sense amplifiers (BLSA), and one of the second connection layers (BP4) corresponding to the one of the first connection layers (BP3) is connected to a second input terminal of the corresponding one of the sense amplifiers (BLSA); and
each of the first connection layers (BP3) is connected to one of the lower bonding pads (P21, P22, P23, P24); and
each of the second connection layers (BP4) is connected to another one of the lower bonding pads (P25, P26, P27, P28).

11. The semiconductor memory device of claim 10, wherein the one of the lower bonding pads (P21, P22, P23, P24) is connected to a corresponding one of the first bit lines (BLO, BL4, BL8, BL12), and the another one of the lower bonding pads (P25, P26, P27, P28) is connected to a corresponding one of the first complementary bit lines (BLBO, BLB4, BLB8, BLB12).

12. The semiconductor memory device of claim 10 or claim 11, wherein a group of the plurality of lower bonding pads (P21, P22, ..., P27, P28) corresponds to both one of the first connection layers (BP3) and a corresponding one of the second connection layers (BP4).

13. The semiconductor memory device of claim 12, wherein half of the group of the lower bonding pads (P21, P22, P23, P24) are connected to the first bit lines (BLO, BL4, BL8, BL12) and a remaining half of the group of the lower bonding pads (P25, P26, P27, P28) are connected to the first complementary bit lines (BLBO, BLB4, BLB8, BLB12).

## Patentansprüche

1. Halbleiter-Speichervorrichtung, umfassend:
einen ersten Chip (1), der eine erste Array-Matrix (AM1) und eine zweite Array-Matrix (AM2) einschließt, die aneinander angrenzend angeordnet sind, mit einem Grenzbereich zwischen der ersten Array-Matrix (AM1) und der zweiten Array-Matrix (AM2), wobei die erste Array-Matrix (AM1) und die zweite Array-Matrix (AM2) jeweils eine Vielzahl von Speicherzellen einschließen; und
einen zweiten Chip (2) unterhalb des ersten Chips (1), wobei der zweite Chip (2) eine Vielzahl von Leseverstärkern (BLSA) einschließt, die dafür konfiguriert sind, die Speicherzellen der ersten Array-Matrix (AM1) und der zweiten Array-Matrix (AM2) anzusteuern,
wobei innerhalb des ersten Chips (1):
eine Vielzahl von ersten Zellen-Bitleitungen (GBL) in der ersten Array-Matrix (AM1) liegen und eine Vielzahl von zweiten Zellen-Bitleitungen (GBL) in der zweiten Array-Matrix (AM2) liegen,
eine Vielzahl von ersten Bitleitungen (BLO, BL4, BL8, BL12) und eine Vielzahl von ersten komplementären Bitleitungen (BLBO, BLB4, BLB8, BLB12) sich in einer anderen Schicht als die Speicherzellen erstrecken, und zwar unterhalb der ersten Array-Matrix (AM1) auf einer ersten Matrix-Array-Seite des Grenzbereichs, und eine Vielzahl von zweiten Bitleitungen (BL2, BL6, BL10, BL14) und eine Vielzahl von zweiten komplementären Bitleitungen (BLB2, BLB6, BLB10, BLB14) sich in einer anderen Schicht als die Speicherzellen erstrecken, und zwar unterhalb der zweiten Array-Matrix (AM2), auf einer zweiten Matrix-Array-Seite des Grenzbereichs, und
jede der ersten Bitleitungen (BLO, BL4, BL8, BL12) mit einer der ersten Zellen-Bitleitungen (GBL) verbunden ist, jede der ersten komplementären Bitleitungen (BLBO, BLB4, BLB8, BLB12) mit einer der zweiten Zellen-Bitleitungen (GBL) verbunden ist, jede der zweiten Bitleitungen (BL2, BL6, BL10, BL14) mit einer der zweiten Zellen-Bitleitungen (GBL) verbunden ist und jede der zweiten komplementären Bitleitungen (BLB2, BLB6, BLB10, BLB14) mit einer der ersten Zellen-Bitleitungen (GBL) verbunden mit,
wobei die Leseverstärker (BLSA) eine Vielzahl von ersten Leseverstärkern (BLSA), von denen sich mindestens ein Abschnitt unterhalb der ersten Array-Matrix (AM1) befindet, und eine Vielzahl von zweiten Leseverstärkern (BLSA), von denen sich mindestens ein Abschnitt unterhalb der zweiten Array-Matrix (AM2) befindet, umfassen,
wobei ein Paar aus einer der ersten Bitleitungen (BLO, BL4, BL8, BL12) und einer entsprechenden der ersten komplementären Bitleitungen (BLBO, BLB4, BLB8, BLB12) mit einem entsprechenden der ersten Leseverstärker (BLSA) verbunden ist,
wobei ein Paar aus einer der zweiten Bitleitungen (BL2, BL6, BL10, BL14) und einer entsprechenden der zweiten komplementären Bitleitungen (BLB2, BLB6, BLB10, BLB14) mit einem entsprechenden der zweiten Leseverstärker (BLSA) verbunden ist,
wobei die Bitleitungen sich in einer ersten Richtung erstrecken und in einer zweiten Richtung, die senkrecht zur ersten Richtung ist, voneinander beabstandet sind, und der erste Chip (1) in einer dritten Richtung, die senkrecht zur ersten und zur zweiten Richtung ist, auf dem zweiten Chip (2) gestapelt ist.
wobei zwischen der einen der ersten Bitleitungen (BLO, BL4, BL8, BL12) und der entsprechenden der ersten komplementären Bitleitungen (BLBO, BLB4, BLB8, BLB12), die gemeinsam mit dem entsprechenden der ersten Leseverstärker (BLSA) verbunden sind, in der zweiten Richtung mindestens eines von einer Abschirmungsleitung (BLS), einer anderen der ersten Bitleitungen (BLO, BL4, BL8, BL12) oder einer anderen der ersten komplementären Bitleitungen (BLBO, BLB4, BLB8, BLB12) angeordnet ist, und
wobei unter der einen der ersten Bitleitungen (BLO, BL4, BL8, BL12) und der entsprechenden der ersten komplementären Bitleitungen (BLBO, BLB4, BLB8, BLB12), die gemeinsam mit dem entsprechenden ersten Leseverstärker (BLSA) verbunden sind, eine eine gerade Linie und die andere eine gebrochene Linie ist, wobei eine gebrochene Linie einen ersten Abschnitt (BLB12(LM2)) und einen zweiten Abschnitt (BLB12(LM2)) aufweist, die sich in der ersten Richtung erstrecken, wobei der erste und der zweite Abschnitt (BLB12(LM2)) mindestens eines von einer Abschirmungsleitung (BLS), einer anderen der ersten Bitleitungen (BLO, BL4, BL8, BL12) oder einer anderen der ersten komplementären Bitleitungen (BLBO, BLB4, BLB8, BLB12) zwischen ihnen angeordnet haben, und wobei der erste und der zweite Abschnitt (BLB12(LM2)) durch einen Verbindungsabschnitt (BLB12(LM3)) verbunden sind, der sich in der zweiten Richtung erstreckt, die erste Richtung kreuzt und in einem isolierten Zustand die mindestens eine der Abschirmungsleitung (BLS), der anderen der ersten Bitleitungen (BLO, BL4, BL8, BL12) BL8, BL12) oder einer anderen der ersten komplementären Bitleitungen (BLBO, BLB4, BLB8, BLB12), die zwischen dem ersten und dem zweiten Abschnitt (BLB12(LM2)) angeordnet sind, kreuzt.

2. Halbleiter-Speichervorrichtung nach Anspruch 1, wobei:
die ersten Zellen-Bitleitungen (GBL), die jeweils mit den ersten Bitleitungen (BLO, BL4, BL8, BL12) verbunden sind, und die ersten Zellen-Bitleitungen (GBL), die jeweils mit den zweiten komplementären Bitleitungen (BLB2, BLB6, BLB10, BLB14), sich miteinander abwechseln; und
die zweiten Zellen-Bitleitungen (GBL), die jeweils mit den ersten komplementären Bitleitungen (BLBO, BLB4, BLB8, BLB12) verbunden sind, und die zweiten Zellen-Bitleitungen (GBL), die jeweils mit den zweiten Bitleitungen (BL2, BL6, BL10, BL14) verbunden sind, sich miteinander abwechseln.

3. Halbleiter-Speichervorrichtung nach Anspruch 2, wobei Verbindungen der ersten Bitleitungen (BLO, BL4, BL8, BL12) und der ersten Zellen-Bitleitungen (GBL), Verbindungen der zweiten komplementären Bitleitungen (BLB2, BLB6, BLB10, BLB14) und der ersten Zellen-Bitleitungen (GBL), Verbindungen der ersten komplementären Bitleitungen (BLB1, BLB4, BLB8, BLB12) und der zweiten Zellen-Bitleitungen (GBL) sowie Verbindungen der zweiten Bitleitungen (BL2, BL6, BL10, BL14) und der zweiten Zellen-Bitleitungen (GBL) im Grenzbereich zwischen der ersten Array-Matrix (AM1) und der zweiten Array-Matrix (AM2) liegen.

4. Halbleiter-Speichervorrichtung nach Anspruch 3, wobei jede der ersten Bitleitungen (BLO, BL4, BL8, BL12), der ersten komplementären Bitleitungen (BLBO, BLB4, BLB8, BLB12), der zweiten Bitleitungen (BL2, BL6, BL10, BL14) und der zweiten komplementären Bitleitungen (BLB2, BLB6, BLB10, BLB14) im ersten Chip (1) liegt und eine Vielzahl von oberen Leiterbahnen (LM0, LM1, LM2, LM3) und eine Vielzahl von oberen Durchkontaktierungen (V1) einschließt.

5. Halbleiter-Speichervorrichtung nach Anspruch 4, wobei der zweite Chip (2) eine Vielzahl von unteren Leiterbahnen (M1, M2, M3, M4, M5) und eine Vielzahl von unteren Durchkontaktierungen (V2) umfasst, die das Paar aus einer der ersten Bitleitungen und der entsprechenden der ersten komplementären Bitleitungen und das Paar aus einer der zweiten Bitleitungen und der entsprechenden der zweiten komplementären Bitleitungen mit den Leseverstärkern (BLSA) verbinden.

6. Halbleiter-Speichervorrichtung nach Anspruch 5, wobei:
der erste Chip (1) eine obere Bondinsel (P1) einschließt, die mit den oberen Leiterbahnen (LM0, LM1, LM2, LM3) oder den oberen Durchkontaktierungen (V1) verbunden ist;
der zweite Chip (2) eine untere Bondinsel (P2) einschließt, die mit den unteren Leiterbahnen (M1, M2, M3, M4, M5) oder den unteren Durchkontaktierungen (V2) verbunden ist; und
die obere Bondinsel (P1) und die untere Bondinsel (P2) miteinander gebondet sind.

7. Halbleiter-Speichervorrichtung nach Anspruch 1, wobei mindestens die Abschirmungsleitung (14) zwischen der einen der ersten Bitleitungen (BLO, BL4, BL8, BL12) und der entsprechenden der ersten komplementären Bitleitungen (BLBO, BLB4, BLB8, BL12), die gemeinsam mit dem entsprechenden der ersten Leseverstärker (BLSA) verbunden sind, angeordnet ist und die gebrochene Leitung die Abschirmungsleitung (BLS) kreuzt und davon isoliert ist.

8. Halbleiter-Speichervorrichtung nach Anspruch 7, wobei der erste Abschnitt (BLB12(LM2)) und der zweite Abschnitt (BLB12(LM2)) auf beiden Seiten der Abschirmungsleitung (BLS) angeordnet sind, der Verbindungsabschnitt (BLB12(LM3)) die Abschirmungsleitung (BLS) kreuzt und davon isoliert ist, eine erste Durchkontaktierung (V1) die Verbindung zwischen dem ersten Abschnitt (BLB12(LM2)) und dem Verbindungsabschnitt (BLB12(LM3)) bildet und eine zweite Durchkontaktierung (V1) die Verbindung zwischen dem zweiten Abschnitt (BLB12(LM2)) und dem Verbindungsabschnitt (BLB12(LM3)) bildet.

9. Halbleiter-Speichervorrichtung nach Anspruch 8, wobei die gebrochene Leitung mindestens eine unter den ersten Bitleitungen (BLO, BL4, BL8, BL12) und den ersten komplementären Bitleitungen (BLBO, BLB4, BLB8, BLB12) kreuzt und davon isoliert ist.

10. Halbleiter-Speichervorrichtung nach einem vorstehenden Anspruch, wobei:
der zweite Chip (2) eine Vielzahl von unteren Bondinseln (P21, P22, ..., P27, P28), eine Vielzahl von ersten Verbindungsschichten (BP3) und eine Vielzahl von zweiten Verbindungsschichten (BP4) einschließt, welche die ersten Bitleitungen (BLO, BL4, BL8, BL12) und die ersten komplementären Bitleitungen (BLBO, BLB4, BLB8, BLB12) mit den Leseverstärkern (BLSA) verbinden; und
eine der ersten Verbindungsschichten (BP3) mit einem ersten Eingangsanschluss eines entsprechenden der Leseverstärker (BLSA) verbunden ist und eine der zweiten Verbindungsschichten (BP4), die der einen der ersten Verbindungsschichten (BP3) entspricht, mit einem zweiten Eingangsanschluss des entsprechenden der Leseverstärker (BLSA) verbunden ist; und
jede der ersten Verbindungsschichten (BP3) mit einer der unteren Bondinseln (P21, P22, P23, P24) verbunden ist; und
jede der zweiten Verbindungsschichten (BP4) mit einer anderen der unteren Bondinseln (P25, P26, P27, P28) verbunden ist.

11. Halbleiter-Speichervorrichtung nach Anspruch 10, wobei die eine der unteren Bondinseln (P21, P22, P23, P24) mit einer entsprechenden der ersten Bitleitungen (BLO, BL4, BL8, BL12) verbunden ist und die andere der unteren Bondinseln (P25, P26, P27, P28) mit einer entsprechenden der ersten komplementären Bitleitungen (BLBO, BLB4, BLB8, BLB12) verbunden ist.

12. Halbleiter-Speichervorrichtung nach Anspruch 10 oder 11, wobei eine Gruppe der Vielzahl von unteren Bondinseln (P21, P22, ..., P27, P28) sowohl einer der ersten Verbindungsschichten (BP3) als auch einer entsprechenden der zweiten Verbindungsschichten (BP4) entspricht.

13. Halbleiter-Speichervorrichtung nach Anspruch 12, wobei eine Hälfte der Gruppe der unteren Bondinseln (P21, P22, P23, P24) mit den ersten Bitleitungen (BLO, BL4, BL8, BL12) verbunden ist und eine verbleibende Hälfte der Gruppe der unteren Bondinseln (P25, P26, P27, P28) mit den ersten komplementären Bitleitungen (BLBO, BLB4, BLB8, BLB12) verbunden ist.

## Revendications

1. Dispositif de mémoire semi-conducteur, comprenant :
une première puce (1) incluant une première matrice de réseau (AM1) et une deuxième matrice de réseau (AM2) adjacentes l'une à l'autre, avec une région limite entre la première matrice de réseau (AM1) et la deuxième matrice de réseau (AM2), la première matrice de réseau (AM1) et la deuxième matrice de réseau (AM2) incluant chacune une pluralité de cellules de mémoire ; et
une deuxième puce (2) sous la première puce (1), la deuxième puce (2) incluant une pluralité d'amplificateurs de détection (BLSA) configurés pour piloter les cellules de mémoire de la première matrice de réseau (AM1) et de la deuxième matrice de réseau (AM2),
dans lequel, au sein de la première puce (1) :
une pluralité de lignes de bits de première cellule (GBL) sont dans la première matrice de réseau (AM1), et une pluralité de lignes de bits de deuxième cellule (GBL) sont dans la deuxième matrice de réseau (AM2),
une pluralité de premières lignes de bits (BLO, BL4, BL8, BL12) et une pluralité de premières lignes de bits complémentaires (BLBO, BLB4, BLB8, BLB12) s'étendent dans une couche différente des cellules de mémoire, sous la première matrice de réseau (AM1), d'un côté réseau de première matrice de la région limite ; et une pluralité de deuxièmes lignes de bits (BL2, BL6, BL10, BL14) et une pluralité deuxièmes lignes de bits complémentaires (BLB2, BLB6, BLB10, BLB14) s'étendent dans une couche différente des cellules de mémoire, sous la deuxième matrice de réseau (AM2), d'un côté réseau de deuxième matrice de la région limite, et
chacune des premières lignes de bits (BLO, BL4, BL8, BL12) est connectée à une des premières lignes de bits de cellule (GBL), chacune des premières lignes de bits complémentaires (BLBO, BLB4, BLB8, BLB12) est connectée à une des deuxièmes lignes de bits de cellule (GBL), chacune des deuxièmes lignes de bits (BL2, BL6, BL10, BL14) est connectée à une des deuxièmes lignes de bits de cellule (GBL), et chacune des deuxièmes lignes de bits complémentaires (BLB2, BLB6, BLB10, BLB14) est connectée à une des premières lignes de bits de cellule (GBL),
dans lequel les amplificateurs de détection (BLSA) comprennent une pluralité de premiers amplificateurs de détection (BLSA) dont au moins une portion est sous la première matrice de réseau (AM1) et une pluralité de deuxièmes amplificateurs de détection (BLSA) dont au moins une portion est sous la deuxième matrice de réseau (AM2),
dans lequel une paire d'une des premières lignes de bits (BLO, BL4, BL8, BL12) et une correspondante des premières lignes de bits complémentaires (BLBO, BLB4, BLB8, BLB12) sont connectées à un correspondant des premiers amplificateurs de détection (BLSA),
dans lequel une paire d'une des deuxièmes lignes de bits (BL2, BL6, BL10, BL14) et une correspondante des deuxièmes lignes de bits complémentaires (BLB2, BLB6, BLB10, BLB14) sont connectées à un correspondant des deuxièmes amplificateurs de détection (BLSA),
dans lequel les lignes de bits s'étendent dans une première direction et sont espacées les unes des autres dans une deuxième direction, perpendiculaire à la première direction, et la première puce (1) est empilée sur la deuxième puce (2) dans une troisième direction, perpendiculaire aux première et deuxième directions,
dans lequel, entre l'une des premières lignes de bits (BLO, BL4, BL8, BL12) et l'une correspondante des premières lignes de bits complémentaires (BLBO, BLB4, BLB8, BLB12) connectées en commun à l'un correspondant des premiers amplificateurs de détection (BLSA), dans la deuxième direction, au moins une ligne de blindage (BLS), une autre des premières lignes de bits (BLO, BL4, BL8, BL12) ou une autre des premières lignes de bits complémentaires (BLBO, BLB4, BLB8, BLB12) est positionnée, et
dans lequel, parmi l'une des premières lignes de bits (BLO, BL4, BL8, BL12) et l'une correspondante des premières lignes de bits complémentaires (BLBO, BLB4, BLB8, BLB12) qui sont connectées en commun à l'un correspondant des premiers amplificateurs de détection (BLSA), une est une ligne droite et l'autre une ligne réfractée, une ligne réfractée présentant une première portion (BLB12(LM2)) et une deuxième portion (BLB12(LM2)) qui s'étendent dans la première direction, les première et deuxième portions (BLB12(LM2)), présentant au moins une ligne de blindage (BLS), une autre des premières lignes de bits (BLO, BL4, BL8, BL12) ou une autre des premières lignes de bits complémentaires (BLBO, BLB4, BLB8, BLB12) disposées entre elles, et les première et deuxième portions (BLB12(LM2)) sont connectées par une portion de connexion (BLB12(LM3)) qui s'étend dans la deuxième direction traversant la première direction et traversant, dans un état isolé, l'au moins une des lignes de blindage (BLS), une autre des premières lignes de bits (BLO, BL4, BL8, BL12), ou une autre des premières lignes de bits complémentaires (BLBO, BLB4, BLB8, BLB12) disposées entre les première et deuxième portions (BLB12(LM2)).

2. Dispositif de mémoire semi-conducteur selon la revendication 1, dans lequel :
les premières lignes de bits de cellule (GBL) respectivement connectées aux premières lignes de bits (BLO, BL4, BL8, BL12) et les premières lignes de bits de cellule (GBL) respectivement connectées aux deuxièmes lignes de bits complémentaires (BLB2, BLB6, BLB10, BLB14) alternent entre elles ; et
les deuxièmes lignes de bits de cellule (GBL) respectivement connectées aux premières lignes de bits complémentaires (BLBO, BLB4, BLB8, BLB12) et les deuxièmes lignes de bits de cellule (GBL) respectivement connectées aux deuxièmes lignes de bits (BL2, BL6, BL10, BL14) alternent entre elles.

3. Dispositif de mémoire semi-conducteur selon la revendication 2, dans lequel des connexions des premières lignes de bits (BLO, BL4, BL8, BL12) et des premières lignes de bits de cellule (GBL), des connexions des deuxièmes lignes de bits complémentaires (BLB2, BLB6, BLB10, BLB14) et des premières lignes de bits de cellule (GBL), des connexions des premières lignes de bits complémentaires (BLB1, BLB4, BLB8, BLB12) et des deuxièmes lignes de bits de cellule (GBL), et des connexions des deuxièmes lignes de bits (BL2, BL6, BL10, BL14) et des deuxièmes lignes de bits de cellule (GBL) sont dans la région limite entre la première matrice de réseau (AM1) et la deuxième matrice de réseau (AM2).

4. Dispositif de mémoire semi-conducteur selon la revendication 3, dans lequel chacune des premières lignes de bits (BLO, BL4, BL8, BL12), des premières lignes de bits complémentaires (BLBO, BLB4, BLB8, BLB12), des deuxièmes lignes de bits (BL2, BL6, BL10, BL14) et des deuxièmes lignes de bits complémentaires (BLB2, BLB6, BLB10, BLB14) est dans la première puce (1), et inclut une pluralité de fils supérieurs (LM0, LM1, LM2, LM3) et une pluralité de vias supérieurs (V1).

5. Dispositif de mémoire semi-conducteur selon la revendication 4, dans lequel la deuxième puce (2) comprend une pluralité de fils inférieurs (M1, M2, M3, M4, M5) et une pluralité de vias inférieurs (V2) qui connectent la paire d'une des premières lignes de bits et une correspondante des premières lignes de bits complémentaires, et la paire d'une des deuxièmes lignes de bits et une correspondante des deuxièmes lignes de bits complémentaires aux amplificateurs de détection (BLSA).

6. Dispositif de mémoire semi-conducteur selon la revendication 5, dans lequel :
la première puce (1) inclut une pastille de liaison supérieure (P1) connectée aux fils supérieurs (LM0, LM1, LM2, LM3) ou aux vias supérieurs (V1) ;
la deuxième puce (2) inclut une pastille de liaison inférieure (P2) connectée aux fils inférieurs (M1, M2, M3, M4, M5) ou aux vias inférieurs (V2) ; et
la pastille de liaison supérieure (P1) et la pastille de liaison inférieure (P2) sont liées l'une à l'autre.

7. Dispositif de mémoire semi-conducteur selon la revendication 1, dans lequel au moins la ligne de blindage (14) est positionnée entre l'une des premières lignes de bits (BLO, BL4, BL8, BL12) et l'une correspondante des premières lignes de bits complémentaires (BLBO, BLB4, BLB8, BLB12) connectées en commun à l'un correspondant des premiers amplificateurs de détection (BLSA), et la ligne réfractée traverse et est isolée de la ligne de blindage (BLS).

8. Dispositif de mémoire semi-conducteur selon la revendication 7, dans lequel la première partie (BLB12(LM2)) et la deuxième partie (BLB12(LM2)) sont positionnées des deux côtés de la ligne de blindage (BLS), la portion de connexion (BLB12(LM3)) traversant et isolée de la ligne de blindage (BLS), un premier via (V1) connectant la première portion (BLB12(LM2)) et la portion de connexion (BLB12(LM3)), et un deuxième via (V1) connectant la deuxième portion (BLB12(LM2)) et la portion de connexion (BLB12(LM3)).

9. Dispositif de mémoire semi-conducteur selon la revendication 8, dans lequel la ligne réfractée traverse et est isolée d'au moins une parmi les premières lignes de bits (BLO, BL4, BL8, BL12) et les premières lignes de bits complémentaires (BLBO, BLB4, BLB8, BLB12).

10. Dispositif de mémoire semi-conducteur selon une quelconque revendication précédente, dans lequel :
la deuxième puce (2) inclut une pluralité de pastilles de liaison inférieures (P21, P22, ..., P27, P28), une pluralité de premières couches de connexion (BP3) et une pluralité de deuxièmes couches de connexion (BP4) qui connectent les premières lignes de bits (BLO, BL4, BL8, BL12) et les premières lignes de bits complémentaires (BLBO, BLB4, BLB8, BLB12) aux amplificateurs de détection (BLSA) ; et
une des premières couches de connexion (BP3) est connectée à une première borne d'entrée d'un correspondant des amplificateurs de détection (BLSA), et une des deuxièmes couches de connexion (BP4) correspondant à l'une des premières couches de connexion (BP3) est connectée à une deuxième borne d'entrée de l'un correspondant des amplificateurs de détection (BLSA) ; et
chacune des premières couches de connexion (BP3) est connectée à une des pastilles de liaison inférieures (P21, P22, P23, P24) ; et
chacune des deuxièmes couches de connexion (BP4) est connectée à une autre des pastilles de liaison inférieures (P25, P26, P27, P28).

11. Dispositif de mémoire semi-conducteur selon la revendication 10, dans lequel l'une des pastilles de liaison inférieures (P21, P22, P23, P24) est connectée à une correspondante des premières lignes de bits (BLO, BL4, BL8, BL12), et l'autre des pastilles de liaison inférieures (P25, P26, P27, P28) est connectée à une correspondante des premières lignes de bits complémentaires (BLBO, BLB4, BLB8, BLB12).

12. Dispositif de mémoire semi-conducteur selon la revendication 10 ou la revendication 11, dans lequel un groupe de la pluralité de pastilles de liaison inférieures (P21, P22, ..., P27, P28) correspond à la fois à une des premières couches de connexion (BPS) et à une correspondante des deuxièmes couches de connexion (BP4).

13. Dispositif de mémoire semi-conducteur selon la revendication 12, dans lequel la moitié du groupe des pastilles de liaison inférieures (P21, P22, P23, P24) est connectée aux premières lignes de bits (BLO, BL4, BL8, BL12) et une moitié restante du groupe de pastilles de liaison inférieures (P25, P26, P27, P28) est connectée aux premières lignes de bits complémentaires (BLBO, BLB4, BLB8, BLB12).
